# EUROPEAN PATENT APPLICATION

(11) **EP 2 555 263 A1**
(43) Date of publication of application: **06.02.2013**
(21) Application number: 11759444.0
(22) Date of filing: 23.03.2011
(51) Int. Cl.: H01L 33/60

(54) **LIGHT-REFLECTING SUBSTRATE, SUBSTRATE WHICH CAN BE MOUNTED IN LIGHT-EMITTING ELEMENT, LIGHT-EMITTING DEVICE, AND PROCESS FOR PRODUCTION OF SUBSTRATE WHICH CAN BE MOUNTED IN LIGHT-EMITTING ELEMENT**

(30) Priority: 27.07.2010 JP 2010168207; 26.03.2010 JP 2010071484
(71) Applicant: Kyocera Corporation, Kyoto-shi Kyoto 612-8501 (JP)
(72) Inventor: OGATA,Ryokichi, Kirishima-shi Kagoshima 899-4396 (JP)
(74) Representative: Beetz & Partner
(86) International application number: PCT/JP2011/056993
(87) International publication number: WO 2011/118639

(57) **Abstract**

A method for manufacturing a light-emitting-element mounting substrate (9) includes a step of applying a glass paste (33) using powder of a glass material having a softening point higher than a softening point of a glass component contained in a glass-ceramic green sheet (11) and lower than a melting point of silver so as to cover a conductor paste (22) which is applied to a main surface of the glass-ceramic green sheet (11) and consists of or consists primarily of silver; and a step of coating a metal layer (2) obtained by heating them and sintering the conductor paste (22), with a transparent glass layer (3) obtained by melting and then cooling the glass paste (33). By using the glass paste (33), the reaction of silver in the conductor paste (22) with the glass component in the glass paste (33) upon heating is suppressed, and the metal layer (2) can be coated with the glass layer (3) having high transparency.

## Description

### Technical Field

The invention relates to a light-reflecting substrate including a metal layer for reflecting light, a light-emitting-element mounting substrate produced using the light-reflecting substrate, for mounting a light-emitting element such as a light-emitting diode or a semiconductor laser diode, a light-emitting device configured by mounting a light-emitting-element on the light-emitting-element mounting substrate, and a method for manufacturing the light-emitting-element mounting substrate.

### Background Art

In recent years, light-emitting elements such as light-emitting diodes (LEDs) or semiconductor lasers (LDs) are used as light sources in various fields such as lighting, mobile phones, and backlights for large-size liquid crystal televisions. Light sources using such light-emitting elements are required to have characteristics such as high reliability, high luminous efficiency, and a low heating value. In particular, there is demand for the ability to maintain high luminous efficiency over a long period of time.

In order to satisfy such demand or for the purpose of improving, for example, protection against mechanical shocks from the outside and chemical action and the mountability of a printed circuit board or the like on an external substrate (e.g., electrical connection reliability), light-emitting elements are generally used in the form of a light-emitting device in which the light-emitting elements are mounted on a light-emitting-element mounting substrate and sealed with a resin or the like that contains a phosphor component.

A light-emitting-element mounting substrate is produced using a light-reflecting substrate that is configured by depositing a metal layer for reflecting light on the main surface of an insulating substrate. For example, a metal material containing silver, which is a substance having high optical reflectivity (whose optical reflectivity with visible light is highest among metal materials), is used as the metal material for forming the metal layer. The metal material containing silver is such as silver or an alloy consisting primarily of silver.

### Citation List

### Patent Literature

Patent Literature 1: Japanese Unexamined Patent Publication JP-A 2009-231440
Patent Literature 2: Japanese Unexamined Patent Publication JP-A 2010-34487
Patent Literature 3: Japanese Unexamined Patent Publication JP-A 2006-140360

### Summary of Invention

### Technical Problem

In a case where a metal layer containing silver is used in a light-reflecting substrate, optical reflectivity may decrease because silver is a substance that can undergo sulfuration or oxidation and therefore the surface of the metal layer may be discolored into yellow, black or the like due to such sulfuration. Also, with a light-emitting-element mounting substrate, in a case where a light-emitting element and a portion of a metal layer that is to be irradiated with the light emitted from the light-emitting element are sealed with resin after the light-emitting element has been mounted on an insulating substrate, discoloration of the metal layer may occur because resin has the property of water absorption, and as a result, the metal layer is protected insufficiently against moisture or the like in the outside air.

To address such problems, for example, means as disclosed in Patent Literature 1 is conceivable, with which after a silver-based wiring conductor (metal layer) has been formed, a glass material (glass paste) is applied so as to cover the surface of the metal layer and then fired into a transparent colorless glass layer that covers the metal layer, and this glass layer serves to suppress a chemical change such as sulfuration of silver while enabling light transmission.

However, processing costs tend to increase with such a light-emitting-element mounting substrate because, in the process for producing the substrate, it is necessary to once form a silver-based conductor layer (metal layer) by firing and then again fire the metal layer such that a glass layer is deposited on the metal layer so as to cover the metal layer. Furthermore, in the case where there is demand for a small-size light-emitting device or so-called multi-chipping in which a plurality of light-emitting elements are mounted on a single insulating substrate, it may be difficult to form such a glass layer that accurately covers only a metal layer because in such a production process, an unfired glass-ceramic material is fired once and then a glass layer is formed on the main surface of an insulating substrate and a metal layer, both of which have reduced dimensions as a result of shrinkage.

Furthermore, in a case where a frame-shaped reflector portion that surrounds a light-emitting element is provided, the reflector portion becomes a hindrance and makes it difficult to apply a glass paste that is to be a glass layer to the surface of a metal layer.

In view of this, a production process is conceivable in which both a metal layer and a glass layer are formed by co-firing with an insulating substrate, i.e., a process is conceivable in which an unfired glass material (such as a glass paste) is applied so as to cover an unfired metal layer (such as a conductor paste) and the glass material and the metal layer are co-fired with an insulating substrate (see Patent Literature 2, for example).

However, in a case where a glass paste is applied to a conductor paste consisting primarily of silver and these pastes are co-fired, silver and the glass react with each other during firing and silver tends to be diffused into the glass, for example, the exposed surface of the glass. Then, there is the possibility that the reflectivity of light from the metal layer to the outside may decrease as a result that the glass layer is colored (discolored into yellow) due to oxidation or sulfuration of the diffused silver component and the degree of transparency of the glass layer is reduced.

The invention has been achieved in light of such conventional problems, and it is an object of the invention to provide a light-reflecting substrate, a light-emitting-element mounting substrate, and a light-emitting device that are configured by depositing a metal layer containing silver on a main surface of an insulating substrate and enable suppression of discoloration due to oxidation or sulfuration of the metal layer. It is also an object of the invention to provide a production process that enables the production of a light-emitting-element mounting substrate capable of maintaining high optical reflectivity over a long period of time as a result that discoloration due to oxidation or sulfuration of a metal layer containing silver is suppressed by depositing the metal layer on a main surface of an insulating substrate through co-firing with a glass layer that covers the metal layer, while suppressing diffusion of silver into the glass layer.

### Solution to Problem

The invention provides a light-reflecting substrate including an insulating substrate and a metal layer containing silver and deposited on a main surface of the insulating substrate, the metal layer being covered with a glass layer having a softening point lower than a melting point of silver, a surface of the glass layer on an opposite side of the silver-containing metal layer side being silver-free.

Furthermore, in the above-described configuration of the light-reflecting substrate of the invention, it is preferable that at least one of the silver-containing metal layer and the glass layer contains at least one of cesium, rubidium, and strontium.

Furthermore, in the above-described configuration of the light-reflecting substrate of the invention, it is preferable that the glass layer contains at least one of zirconium oxide, aluminum oxide, titanium oxide, and niobium oxide.

Furthermore, in the above-described configuration of the light-reflecting substrate of the invention, it is preferable that the insulating substrate is made of glass-ceramics, the insulating substrate, the silver-containing metal layer, and the glass layer are formed by co-firing, and the glass layer is formed by firing a first glass material having a softening point higher than a softening point of a second glass material which is to be a glass component of the glass-ceramics by the co-firing and lower than the melting point of silver.

The invention provides a light-emitting-element mounting substrate including the light-reflecting substrate with one of the above-described configurations, and a mounting portion where a light-emitting element is to be mounted, in the main surface of the insulating substrate to which the silver-containing metal layer has been deposited.

The invention provides a process for producing a light-emitting-element mounting substrate including:
a first step of preparing a glass-ceramic green sheet and applying a conductor paste to at least part of a main surface of the glass-ceramic green sheet, the conductor paste having been produced by dispersing a conductor material consisting of or consisting primarily of silver in an organic solvent,
a second step of producing a glass paste using powder of a glass material having a softening point higher than a softening point of a glass component contained in the glass-ceramic green sheet and lower than a melting point of silver, and applying the glass paste so as to cover the conductor paste applied to the main surface of the glass-ceramic green sheet, and
a third step of heating and sintering the glass-ceramic green sheet to which the conductor paste and the glass paste have been applied, so as to form an insulating substrate composed of glass-ceramics, sintering the conductor paste so as to deposit a metal layer consisting of or consisting primarily of silver on a main surface of the insulating substrate, and melting and then cooling the powder of the glass material of the glass paste so as to form a transparent glass layer with which the metal layer is covered.

Furthermore, in the process for producing a light-emitting-element mounting substrate, it is preferable that at least one of cesium, rubidium, and strontium is added to at least one of the conductor paste produced in the first step and the glass paste produced in the second step.

Furthermore, in the process for producing a light-emitting-element mounting substrate, it is preferable that at least one of zirconium oxide, aluminum oxide, titanium oxide, and niobium oxide is added to the glass paste produced in the second step.

Furthermore, it is preferable that the process for producing a light-emitting-element mounting substrate includes, prior to heating the glass-ceramic green sheet to which the conductor paste and the glass paste have been applied, a step of producing a constraining glass-ceramic green sheet or a constraining glass-ceramic paste using a second glass component having a glass transition point different from that of the glass component contained in the glass-ceramic green sheet, and depositing the constraining glass-ceramic green sheet or the constraining glass-ceramic paste on another main surface of the glass-ceramic green sheet that is opposite to the main surface.

Furthermore, in the process for producing a light-emitting-element mounting substrate, it is preferable that the first step further includes a step of preparing a frame-shaped glass-ceramic green sheet in addition to the glass-ceramic green sheet and applying the conductor paste also to an inner side surface of the frame-shaped glass-ceramic green sheet, and the second step further includes a step of applying the glass paste so as to cover the conductor paste applied to the inner side surface of the frame-shaped glass-ceramic green sheet, and laminating the frame-shaped glass-ceramic green sheet on the main surface of the glass-ceramic green sheet so as to form a frame portion that surrounds a portion where the light-emitting element is to be mounted.

### Advantageous effects of Invention

According to the light-reflecting substrate of the invention, oxidation and sulfuration of a silver component of the metal layer can be suppressed because the metal layer is covered with the glass layer having a softening point lower than a melting point of silver. Furthermore, due to the absence of silver in the surface of this glass layer on the opposite side of the metal layer, it is possible to suppress discoloration of the glass layer due to oxidation, sulfuration or the like of silver exposed to that surface, and degradation in light transmissivity that accompanies such discoloration. Accordingly, it is possible to provide a light-reflecting substrate capable of suppressing discoloration due to oxidation or sulfuration of the metal layer containing silver.

According to the light-emitting-element mounting substrate according to the invention, like the above-described light-reflecting substrate, it is possible to provide a light-emitting-element mounting substrate capable of suppressing oxidation and sulfuration of a silver component of the metal layer.

According to the light-emitting device of the invention, the light-emitting device is configured by mounting a light-emitting element on the mounting portion of the above-described light-emitting-element mounting substrate. It is thus possible to provide a light-emitting device capable of suppressing oxidation and sulfuration of a silver component of the metal layer.

According to the process for producing a light-emitting-element mounting substrate of the invention, the production process includes the above-described steps. Accordingly, in a produced light-emitting-element mounting substrate, it is possible for the glass layer to prevent discoloration due to a chemical change such as sulfuration of silver and prevent a change in reflectivity with time.

Specifically, in the above-described production process, since the softening point of the glass material is higher than the softening point of the glass component of the glass-ceramic green sheet, the glass material starts to be softened after the glass component has been softened and sintering of silver and the glass-ceramics (liquid-phase sintering of the glass component) has been substantially completed. This makes it possible to suppress diffusion of silver into the glass material, suppress discoloration of the glass material and by extension the glass layer due to diffusion of silver into the glass material, and thereby improve reflectivity. Furthermore, since the softening point of the glass material is lower than the melting point of silver, silver does not melt during the softening of the glass material. Accordingly, it is possible to deposit the metal layer containing silver on the main surface of an insulating substrate through co-firing with the glass layer that covers the metal layer, while suppressing diffusion of silver into the glass layer. This makes it possible to provide a production process that enables the production of a light-emitting-element mounting substrate capable of maintaining high optical reflectivity of the metal layer over a long period of time.

### Brief Description of Drawings

Fig. 1(a) is a top view showing an example of an embodiment of a light-reflecting substrate according to the invention, Fig. 1(b) is a cross-sectional view taken along the line A-A in Fig. 1(a), and Fig. 1(c) is an enlarged cross-sectional view schematically showing a main part of Fig. 1(b);
Fig. 2(a) is a top view showing an example of an embodiment of a light-emitting-element mounting substrate according to the invention, and Fig. 2(b) is a cross-sectional view taken along the line B-B in Fig. 2(a);
Figs. 3(a) to 3(d) are cross-sectional views showing an example of the process for producing a light-emitting-element mounting substrate according to the invention in order of steps;
Fig. 4(a) is a cross-sectional view showing an example of a light-emitting-element mounting substrate produced by a process for producing a light-emitting-element mounting substrate according to the invention, and Fig. 4(b) is a top view of Fig. 4(a);
Fig. 5 is a cross-sectional view showing a step in another example of the process for producing a light-emitting-element mounting substrate according to the invention;
Fig. 6 is a cross-sectional view showing another example of the light-emitting-element mounting substrate produced by the process for producing a light-emitting-element mounting substrate according to the invention;
Fig. 7 is a cross-sectional view showing another example of the light-emitting-element mounting substrate produced by the process for producing a light-emitting-element mounting substrate according to the invention;
Figs. 8(a) to 8(c) are cross-sectional views showing another example of the process for producing a light-emitting-element mounting substrate according to the invention in order of steps;
Fig. 9(a) is a cross-sectional view showing another example of the light-emitting-element mounting substrate produced by the production process according to the invention, and Fig. 9(b) is a top view of Fig. 9(a);
Fig. 10 is a cross-sectional view showing another example of the light-emitting-element mounting substrate produced by the process for producing a light-emitting-element mounting substrate according to the invention;
Fig. 11 is a cross-sectional view showing another example of the light-emitting-element mounting substrate produced by the process for producing a light-emitting-element mounting substrate according to the invention; and
Fig. 12 is a cross-sectional view showing another example of the light-emitting-element mounting substrate produced by the process for producing a light-emitting-element mounting substrate according to the invention.

### Description of Embodiments

Now, a light-reflecting substrate, a light-emitting-element mounting substrate, and a light-emitting device according to the invention will be described with reference to the accompanying drawings. Note that in the following description, light (visible light) reflectivity may be simply referred to as "reflectivity".

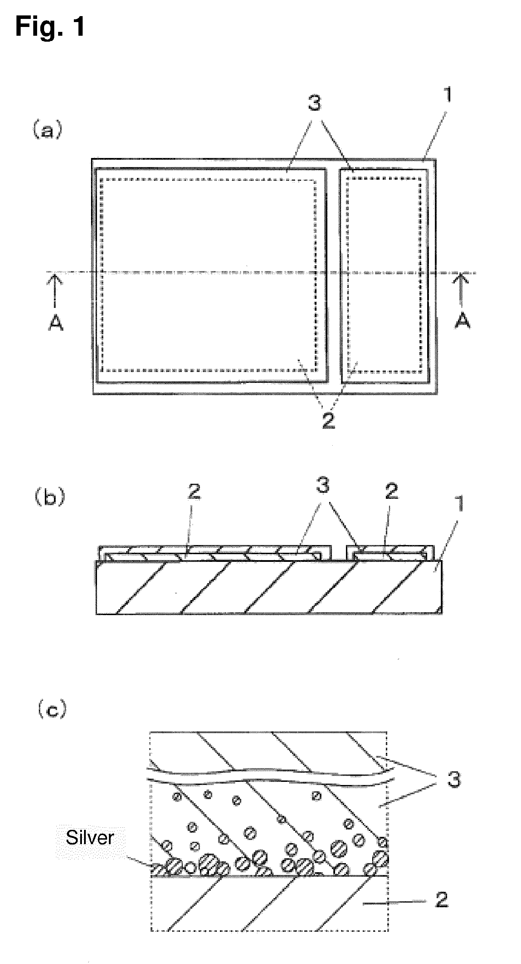

Fig. 1(a) is a top view showing an example of an embodiment of the light-reflecting substrate according to the invention, Fig. 1(b) is a cross-sectional view taken along the line A-A in Fig. 1(a), and Fig. 1(c) is an enlarged cross-sectional view schematically showing a main part of Fig. 1(b). The light-reflecting substrate is basically configured such that a metal layer 2 deposited on a main surface (upper surface) of an insulating substrate 1 is covered with a glass layer 3.

The light-reflecting substrate 1 is used in various applications where light is reflected, such as a light-emitting-element mounting substrate for mounting a light-emitting element or a reflector (light-reflecting plate) used in a light-emitting device.

The insulating substrate 1 has a shape and dimensions in accordance with the application, and is made of an insulating material such as glass-ceramics, sintered aluminum oxide, or sintered mullite. For example, in a case where the light-reflecting substrate is used as a light-emitting-element mounting substrate, the insulating substrate 1 is formed in the shape of a quadrangular plate or the like that has dimensions large enough to mount a light-emitting element on the main surface thereof.

The insulating substrate 1 can be produced by, for example, forming an unfired glass-ceramic material into a predetermined shape of insulating substrate 1 together with an organic solvent and a binder and firing them.

The metal layer 2 is a portion for reflecting light and is deposited in layers on a main surface (in the example of Fig. 1, the upper surface) of the insulating substrate 1. The metal layer 2 is formed of a metal material containing silver, in order to improve reflectivity. Examples of the metal material containing silver include metal materials consisting primarily of silver and including an alkali metal or an alkaline earth metal added thereto. Examples of such an alkali metal and an alkaline earth metal include cesium, rubidium, and strontium. Note that the metal layer 2 may consist of silver.

The metal layer 2 can be formed by, for example, applying a metal paste, which is produced by adding an organic solvent and a binder to silver powder and kneading them, to the main surface of the insulating substrate 1 and heating and sintering them. The metal layer 2 may be formed by co-firing with the insulating substrate 1.

The glass layer 3 is a layer that covers the metal layer 2, for preventing oxidation and sulfuration of silver forming the metal layer 2. The glass layer 3 needs to be transparent and have high light transmissivity in order to enable the metal layer 2 to reflect light received from the outside.

The metal layer 2 is covered with the glass layer 3 having a softening point lower than the melting point of silver (approximately 961°C). Therefore, oxidation or sulfuration of a silver component of the metal layer 2 can be suppressed. Furthermore, the surface of this glass layer 3 on the opposite side of the metal layer 3 side (which is, for example, a surface exposed to the air and hereinafter referred to also as an "exposed surface") is silver-free. Accordingly, coloration of the glass layer 3 due to oxidation, sulfuration or the like of exposed silver, and degradation in light transmissivity that accompanies such coloration can be suppressed. It is thus possible to provide a light-reflecting substrate capable of suppressing discoloration due to oxidation or sulfuration of the metal layer 2 containing silver.

Note that the exposed surface of the glass layer 3 being silver-free means that the amount of silver existing in the surface of the glass layer 3 is to such an extent that silver is difficult to detect by measurement using an electron probe x-ray microanalyzer (EPWA) or the like, i.e., to an extent that the range where silver exists in the exposed surface of the glass layer is approximately 0.3% or less in terms of the surface area ratio and therefore silver is regarded as substantially not existing. In this case, even in a case where a trace amount of silver existing in the exposed surface of the glass layer 3 (which is to such an extent that silver is regarded as substantially not existing) undergoes oxidation or sulfuration, the glass layer 3 can still have high light transmissivity.

The purpose of making the softening point of the glass layer 3 lower than the melting point of silver is to prevent the metal layer 2 from melting when forming the glass layer 3 by applying a glass material paste or the like that is to be the glass layer 3 to the exposed surface of the metal layer 2 and heating it.

The softening point of the glass material for forming the glass layer 3 is desirably approximately 900°C or lower in consideration of preventing the aforementioned melting of the metal layer 2 and suppressing diffusion of silver into the exposed surface of the glass layer 3. One example of such a glass material is borosilicate glass that contains at least one of CaO, SrO, Al₂O₃, MgO, and BaO.

For example as shown in Fig. 1(c), the silver component of the metal layer 2 is slightly diffused in the glass layer 3 due to energy such as heat that is generated when depositing the glass layer 3. In this case, the amount of silver existing in the exposed surface of the glass layer 3 as a result of diffusion can be suppressed by keeping the softening point of the glass layer 3 low as described above.

The diffusion of the silver component of the metal layer 2 in the glass layer 3 is desirably 30% or less with respect to the thickness of the glass layer 3. For example, in the example shown in Fig. 1(c), the range where silver is diffused corresponds to the range of 30% with respect to the entire thickness of the glass layer 3. The shape of the silver component diffused in the glass layer 3 is not necessarily limited to a circular shape (spherical shape), and various shapes including an indefinite shape are possible.

Note that the metal layer 2 and the glass layer 3 may be formed by a process of simultaneously heating and firing a metal paste that is to be the metal layer 2 and a glass paste that is to be the glass layer 3.

In a case where at least one of the metal layer 2 and the glass layer 3 contains at least one of cesium, rubidium, and strontium, the above-described light-reflecting substrate can effectively suppress the diffusion of silver into the glass layer 3. It is thus possible, in this case, to provide a light-reflecting substrate that effectively suppresses the amount of silver in the exposed surface of the glass layer 3.

Cesium, rubidium, and strontium have the effect of suppressing the diffusion of silver of the metal layer 2 into the glass layer 3. The reason for this seems to be that cesium or the like hinders the diffusion of silver into the glass layer 3 as a result that the above material such as cesium is diffused into the glass layer 3 prior to diffusion of silver at the time of heating for deposition of the glass layer 3 or that the above material such as cesium is included in advance in the glass layer 3. Furthermore, the above materials such as cesium do not interfere with light transmission in the glass layer 3 because they are colorless and transparent in the glass layer 3.

For example, the metal layer 2 can be caused to include the above material such as cesium by adding the material in the form of carbonates, various types of organic acid salts or the like into a metal paste that is to be the metal layer 2 and firing it together with the metal layer 2 (as well as the glass layer 3, depending on the situation). In the same manner, the glass layer 3 can be caused to include the above material by adding the material in the form of cesium carbonate or the like into a glass paste that is to be the glass layer 3.

In the case of adding the material such as cesium in the form of a salt to a metal paste or a glass paste, the material is preferably of a type of acid salt (e.g., a carbonate described above) that will be decomposed by heat treatment and will not remain within the metal layer 2 or the glass layer 3.

Furthermore, in a case where the glass layer 3 contains at least one of zirconium oxide, aluminum oxide, titanium oxide, and niobium oxide, the above-described light-reflecting substrate can suppress the absorption of light by the glass layer 3 and improve optical reflectivity by allowing part of light passing through the glass layer 3 and travelling toward the metal layer 2 to be moderately reflected within the glass layer 3 (i.e., in the middle of the optical path). This material such as zirconium oxide is preferably included in the glass layer 3 as particles dispersed in the glass layer 3.

In this case, in a case where the content of zirconium oxide or the like is low, the above effect of improving optical reflectivity tends to be small, whereas in a case where that content is high, the reflection of light by zirconium oxide or the like that has lower optical reflectivity than that of silver becomes greater than the reflection of light by the metal layer 2, and as a result, the optical reflectivity of the light-reflecting substrate tends to be reduced. For this reason, the content of zirconium oxide or the like in the glass layer 3 is preferably in the range of approximately 5 to 15% by mass.

Note that the case where the material contained in the glass layer 3 is zirconium oxide is advantageous in the case where the light-reflecting substrate is used as a light-emitting-element mounting substrate because a plating metal cannot be easily precipitated into zirconium oxide. For example, it is possible to more reliably suppress problems such as adhesion of a plating metal such as nickel or gold to zirconium oxide particles existing in the exposed surface of the glass layer 3 when the metal plating layer is deposited the exposed surface of the metal layer 2 in the light-emitting-element mounting substrate as described later.

Furthermore, the case where the material contained in the glass layer 3 is aluminum oxide is advantageous in the case where the light-reflecting substrate is used for the light-emitting-element mounting substrate because aluminum oxide has relatively high thermal conductivity. The relatively high thermal conductivity of aluminum oxide increases the thermal conductivity of the glass layer 3 and improves the property of heat dissipation from the light-emitting element.

The above-described light-reflecting substrate has the following effects in the case where the insulating substrate 1 is formed of glass-ceramics, the insulating substrate 1, the metal layer 2, and the glass layer 3 are formed by co-firing, and the glass layer 3 is formed by firing a first glass material having a softening point higher than a softening point of a second glass material and lower than the melting point of silver, the second glass material being formed into a glass component of the glass-ceramics by co-firing.

Specifically, in this case, since the insulating substrate 1, the metal layer 2, and the glass layer 3 are formed by co-firing, it is possible to keep processing costs low and easily form such a glass layer 3 that accurately covers only the metal layer 2. Furthermore, since the glass layer 3 is formed of the above-described first glass material, the co-firing is carried out such that after the second glass material forming the insulating substrate 1 has been softened and formed into the glass component of the glass-ceramics, the first glass material is softened at a temperature lower than the melting point of silver and formed into the glass layer 3 that covers the metal layer 2. Accordingly, it is possible, in this case, to provide a light-reflecting substrate that effectively suppresses the amount of silver existing in the exposed surface of the glass layer 3 and that is effective in terms of processing costs and in terms of accurately covering the metal layer 2 with the glass layer 3.

Note that in this case, even in a case where a reflector portion (not shown in Fig. 1) for causing the reflection of light to converge in a single direction is provided on the upper surface of the insulating substrate 1, it is easy to form the glass layer 3 that covers the surface of the metal layer 2.

The insulating substrate 1 made of glass-ceramics can be formed by co-firing with the metal layer 2 containing silver because the firing temperature is relatively low (on the order of the melting point of silver).

The insulating substrate 1 can be produced by, for example, forming a raw material powder consisting primarily of aluminum oxide and a glass material such as borosilicate glass together with an organic solvent, a binder and the like into a predetermined form of the insulating substrate 1 and firing them. The glass material forming this insulating substrate 1 is the above-described second glass material and becomes a glass component serving as a primary component of the glass-ceramics through firing.

In this case, the glass layer 3 needs to be formed using the first glass material that satisfies the condition that the softening point of the first glass material is higher than the softening point of the second glass material, in addition to the above-described condition that the softening point of the first glass material is lower than the melting point of silver. The softening point of the first glass material may, for example, be 900°C or lower and approximately 870°C or higher.

The first glass material may be borosilicate glass that contains an additive material of at least one of CaO, SrO, Al₂O₃, MgO, and BaO and whose softening point is adjusted within the above range (of 870 to 900°C) by adjusting the composition ratio of such an additive material to SiO₂ and B₂O₃.

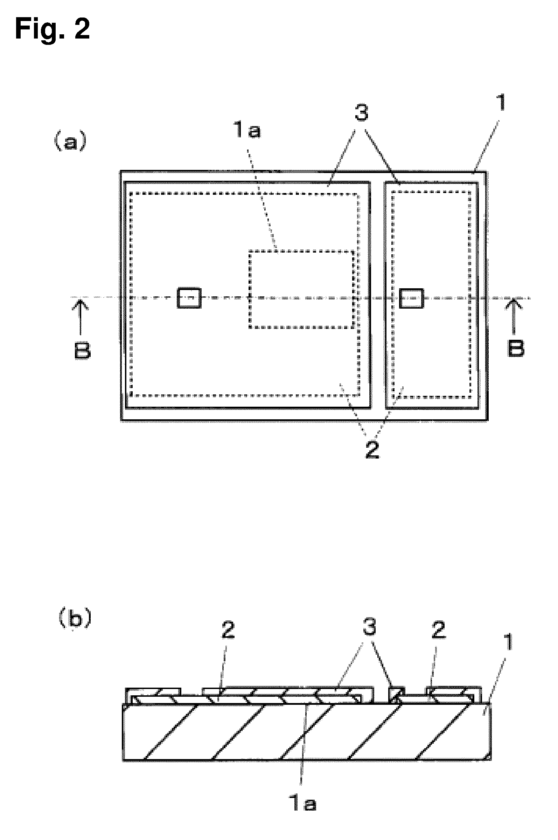

Fig. 2(a) is a top view showing an example of an embodiment of the light-emitting-element mounting substrate according to the invention, and Fig. 2(b) is a cross-sectional view taken along line B-B in Fig. 2(a). In Fig. 2, the same reference numerals have been given to constituent elements that are the same as in Fig 1.

The light-emitting-element mounting substrate includes the above-described light-reflecting substrate and is configured such that a light-emitting-element mounting portion 1a where a light-emitting element (not shown in Fig. 2) is to be mounted is provided in the main surface (upper surface) of the insulating substrate 1 on which the metal layer 2 has been deposited. The light-emitting element is, for example, a light-emitting element (LED) or a semiconductor laser (LD). The light-emitting-element mounting portion 1a is provided in the main surface of the insulating substrate 1 on which the metal layer 2 has been deposited, in order to reflect the light emitted from the light-emitting element to the outside.

Note that in the light-emitting-element mounting substrate, a portion where the light-emitting element is to be actually bonded is not necessarily the main surface itself of the insulating substrate 1 (the exposed surface of the glass-ceramics or the like) and may, for example, be the surface of an insulating layer deposited on the main surface (e.g., the exposed surface of the glass layer 3).

This light-emitting-element mounting substrate has openings (without reference numeral) in parts of the glass layer 3, and the metal layer 2 is exposed through these openings. These exposed portions of the metal layer 2 function as, for example, connection terminals for providing electrical connection for the light-emitting element mounted on the mounting portion 1a via a bonding wire or the like. In a case where parts of the metal layer 2 are exposed to serve as connection terminals, these exposed surfaces are covered with a metal plating layer such as nickel or gold so as to suppress oxidation or sulfuration, improve bonding performance, and the like.

A light-emitting device can be produced by mounting a light-emitting element on the mounting portion 1a of the light-emitting-element mounting substrate and performing necessary processing, such as providing electrical connection between the light-emitting element and the metal layer 2. The light-emitting element mounted on the mounting portion 1a emits light with, for example, current supplied through the metal layer 2, and this light is applied to the outside either directly or after being reflected by the metal layer 2.

The following describes details of the process for producing a light-emitting-element mounting substrate. In the following description of the process for producing a light-emitting-element mounting substrate, the case of production a light-emitting-element mounting substrate with a more practical structure is given as an example, and a light-emitting device is also described in conjunction therewith.

The process for producing a light-emitting-element mounting substrate according to the invention will be described with reference to the accompanying drawings.

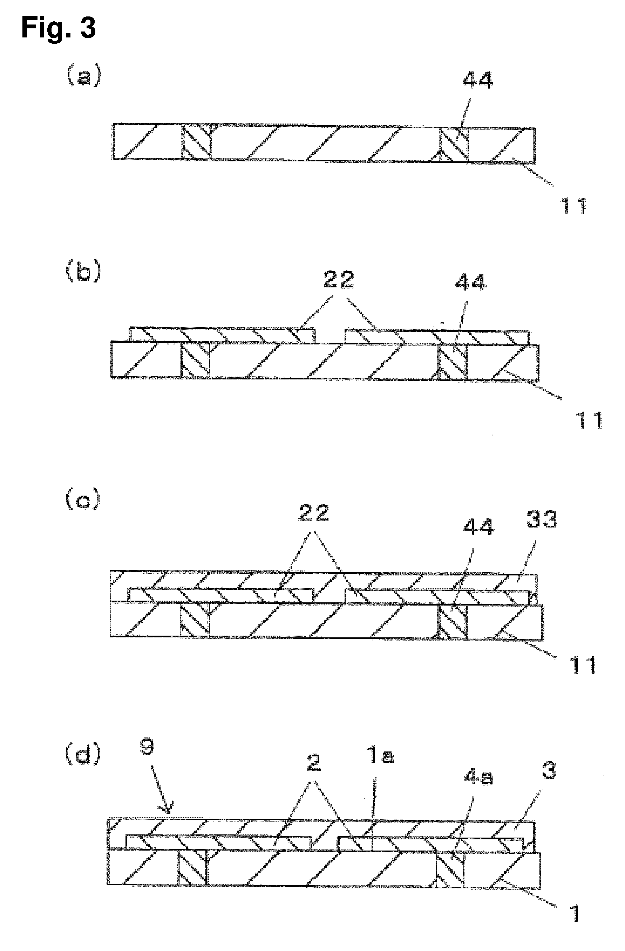

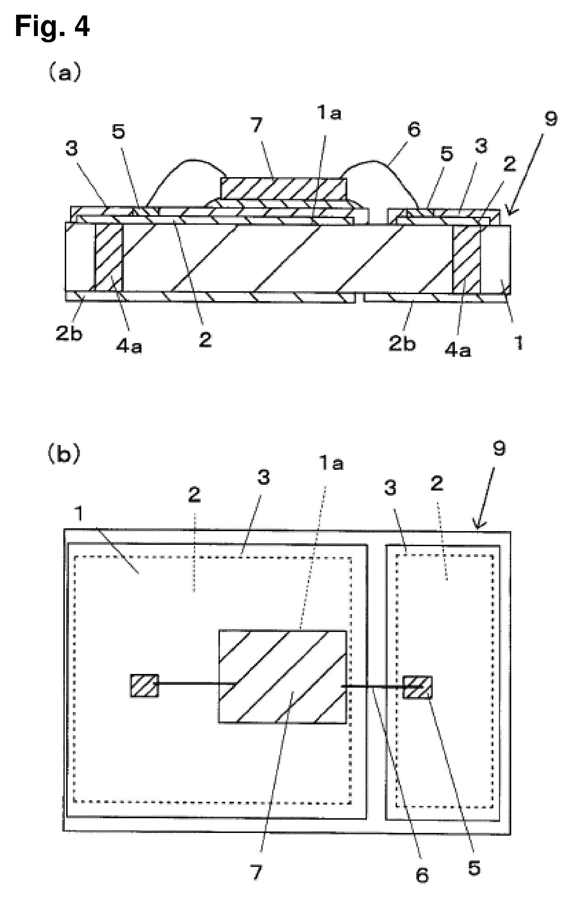

Figs. 3(a) to 3(d) are cross-sectional views showing an example of the process for producing a light-emitting-element mounting substrate according to the invention in order of steps. Fig. 4(a) is a cross-sectional view showing an example of a light-emitting-element mounting substrate produced by the production process of the invention, and a light-emitting device configured by mounting a light-emitting element on this light-emitting-element mounting substrate. Fig. 4(b) is a top view of Fig. 4(a). The light-emitting element or the like is not shown in Fig. 4(b). As shown in Fig. 4, a light-emitting-element mounting substrate 9 is basically configured by an insulating substrate 1 formed of glass-ceramics and including, in the main surface thereof, a portion 1a where a light-emitting element 7 is to be mounted, a metal layer 2 deposited on a portion to be irradiated with the light emitted from the light-emitting element 7, and a glass layer 3 covering the metal layer 2. A light-emitting device is configured by mounting the light-emitting element 7 on the light-emitting-element mounting substrate 9 shown in Fig. 4.

The insulating substrate 1 is a substrate for mounting and protecting the light-emitting element 7, and is formed of glass-ceramics in order to enable co-firing with a conductor paste formed of a conductor material consisting of or consisting primarily of silver, which will be discussed later. In order to mount the light-emitting element 7, the insulating substrate 1 includes, in the main surface, the portion 1a where the light-emitting element is to be mounted (in the example shown in Fig. 4, only the upper surface) thereof, the portion 1a being formed in the shape of, for example, a quadrangular plate such as a rectangle.

The metal layer 2 is, for example, a wiring conductor (without reference numeral) electrically connected to the light-emitting element 7 to be mounted on the insulating substrate 1, for supplying necessary power to the light-emitting element 7, or a reflection layer (without reference numeral) for reflecting the light emitted from the light-emitting element 7 to the outside (in the upward direction). Even in a case where the metal layer 2 is used as a wiring conductor, the metal layer 2 needs to be capable of effectively reflecting the light emitted from the light-emitting element 7, in order to improve the luminous efficiency of the light-emitting device. For this reason, the metal layer 2 is formed of a conductor material that contains silver whose optical reflectivity is highest among metals (the conductor material includes a conductor material consisting of only silver).

The metal layer 2 contains silver and is deposited on a portion to be irradiated with the light emitted from the light-emitting element 7 on the main surface (upper surface) of the insulating substrate 1. Other metal layers (e.g., another metal layer 2b deposited on the lower surface of the insulating substrate 1) may be formed of other metal materials. Note that in the example shown in Fig. 4, the range to be irradiated with the light emitted from the light-emitting element 7 in the main surface of the insulating substrate 1 is the entire upper surface of the insulating substrate 1.

The glass layer 3 is provided for suppressing a chemical change such as sulfuration, oxidation or the like of silver in the metal layer 2 containing silver. This glass layer 3 is formed of a colorless transparent glass material because it needs to transmit the light reflected by the metal layer 2 therethrough without weakening the light as much as possible.

Note that in the example shown in Fig. 4, through-holes (without reference numeral) are formed in parts of the glass layer 3, and these through-holes are filled with a metal plating layer 5 such as nickel or gold. The metal plating layer 5 functions as a connection pad for providing electrical connection between the metal layer 2 and the light-emitting element 7. The light-emitting element 7 and the metal layer 2 such as a wiring conductor are electrically connected by connecting the electrodes of the light-emitting element 7 to this metal plating layer 5 via a bonding wire 6 or the like.

Furthermore, in the example shown in Fig. 4, through-holes (without reference numeral) passing through the insulating substrate 1 in the thickness direction are formed and filled with through-conductors 4a. The through-conductors 4a have the function of, for example, electrically guiding the metal layer 2 deposited on the upper surface of the insulating substrate 1 to the lower surface of the insulating substrate 1. For example, in a case where the metal layer 2 on the upper surface of the insulating substrate 1 is electrically connected to the other metal layer 2b deposited on the lower surface of the insulating substrate 1 through these through-conductors 4a and the other metal layer 2b is electrically connected to an external electric circuit (not shown), the light-emitting element 7 is electrically connected to that external electric circuit.

The following describes details of the process for producing such a light-emitting-element mounting substrate 9.

### (First Step)

First, a glass-ceramic green sheet 11 is prepared as shown in Fig. 3(a), and a conductor paste 22 produced by dispersing a conductor material consisting of or consisting primarily of silver into an organic solvent is applied to, out of the main surface of the glass-ceramic green sheet 11, at least a portion to be irradiated with the light emitted from the light-emitting element 7 as shown in Fig. 3 (b) .

The glass-ceramic green sheet 11 is to be formed by firing into glass-ceramics consisting primarily of a glass component such as borosilicate glass or lithium silicate glass and a ceramic component such as aluminum oxide or calcium oxide. For example, the glass-ceramic green sheet 11 can be prepared using powder of these glass and ceramic components as raw material powder, by forming a ceramic paste produced by kneading the raw material powder together with an organic solvent, an organic binder and the like into sheet form, employing sheet forming technique such as doctor blade processing or lip coater processing.

The glass-ceramic green sheet 11 has, for example, a thickness of approximately 100 to 300 µm. A configuration is also possible in which a plurality of such glass-ceramic green sheets are prepared and laminated one above another in a subsequent step. In the case where a plurality of glass-ceramic green sheets (not shown) are laminated and formed into a stacked body, which is to be the insulating substrate 1, the stacked body may be formed in the shape of, for example, a rectangular plate or a square plate that has a thickness of approximately 300 to 1500 µm and an outer-side length of approximately 2.5 mm to 10 mm as viewed in a plan view.

The conductor paste 22 can be produced by kneading powder of conductor material consisting of or consisting primarily of silver with an organic solvent and a binder. Examples of the above powder of conductor material include powder consisting primarily of silver powder and including an additive of carbonate powder made of an alkali-metal element or an alkaline-earth-metal element, such as cesium carbonate, rubidium carbonate, or strontium carbonate. In this case, the content of silver (powder) in the powder of conductor material containing silver is preferably approximately 95 to 100% by mass in terms of improving the optical reflectivity of the metal layer 2.

Note that in the conductor paste 22 using a conductor material consisting primarily of silver, the above-described additive such as a carbonate has the effect of suppressing diffusion of silver into a glass paste 33 in a later-described step including firing. This effect is the same as achieved with the above-described light-reflecting substrate and light-emitting-element mounting substrate of the invention. Specifically, the above-described additive such as a carbonate suppresses ionization and subsequent diffusion of silver into the glass paste 33 because it is easily decomposed and ionized during firing and therefore diffused in the glass paste 33 ahead of silver. In this case, the above-described material such as an alkali-metal element or an alkaline-earth-metal element does not interfere with light transmission in the glass layer 3 because it is colorless and transparent in the fired glass paste 33 (glass layer 3).

Note that cesium, rubidium, and strontium may be added in the form of various types of organic acid (carboxylic acid) salts other than a carbonate. Furthermore, cesium, rubidium, and strontium may be added to the glass paste to be produced in a second step described later. In this case as well, the effect of suppressing the diffusion of silver can be achieved in the same manner.

The conductor paste 22 is applied to, out of the main surface of the glass-ceramic green sheet 11, at least a portion to be irradiated with the light emitted from the light-emitting element 7, that is, the upper surface of the glass-ceramic green sheet 11 in the present example. In this case, the conductor paste 22 does not necessarily have to be applied to the entire upper surface of the glass-ceramic green sheet 11 and may be applied in a predetermined pattern of wiring conductor or reflecting layer.

Note that in the example shown in Fig. 3(a), the through-holes (without reference numeral) are formed by subjecting the glass-ceramic green sheet 11 to puncing processing such as punching using a mold, and another conductor paste 44 different from the above-described conductor paste 22 is filled in these through-holes. The other conductor paste 44 may consist primarily of a metal other than silver, such as copper, platinum, or gold, or it may consist primarily of silver, like the conductor paste 22. The other conductor paste 44 filled in the through-holes is to be formed into, for example, the through-conductors 4a as shown in Fig. 4 through firing in a subsequent step.

### (Second Step)

Next, as shown in Fig. 3(c), the glass paste 33 is produced from powder of a glass material having a softening point higher than the softening point of the glass component contained in the glass-ceramic green sheet 11 and lower than the melting point of silver, and this glass paste 33 is applied so as to cover the conductor paste 22 applied to the main surface of the glass-ceramic green sheet 11.

Examples of the composition of the glass component having a softening point higher than the softening point of the glass component contained in the glass-ceramic green sheet 11 and lower than the melting point of silver (approximately 961°C) include borosilicate glass that contains SiO₂ and B₂O₃ and contains at least one of CaO, SrO, Al₂O₃, MgO, and BaO.

The softening point of the glass material can be adjusted by, for example, changing the composition ratio of the material selected from among CaO, SrO, Al₂O₃, MgO, and BaO to SiO₂ and B₂O₃.

This glass paste 33 is formed into the transparent glass layer 3 by heating in the next step, for covering the metal layer 2 and suppressing discoloration of the metal layer 2 due to a chemical reaction such as sulfuration or the like of silver. For this reason, the glass paste 33 needs to be applied so as to cover the conductor paste 22 applied to the main surface of the glass-ceramic green sheet 11.

As described previously, the glass paste 33 may be configured by adding cesium, rubidium, and strontium in the form of a carbonate, an organic acid salt or the like, so as to effectively suppress diffusion of silver into the glass paste 33 during firing in the subsequent step. The material such as cesium added in advance to the glass paste 33 serves to prevent the diffusion of silver into the glass paste 33 (glass layer 3). Furthermore, these materials such as cesium do not interfere with light transmission in the glass layer 3 because they are colorless and transparent in the glass layer 3.

The thickness of the glass paste 33 to be applied is preferably as large as possible in terms of suppressing discoloration of the metal layer 2, whereas it is preferably as small as possible in terms of facilitating light transmission in the glass layer 3. Accordingly, the actual thickness of the glass paste 33 to be applied may be appropriately set, taking into consideration how much effect of suppressing discoloration of the metal layer 2 is required (e.g., an environment for using the light-emitting device produced with this light-emitting-element mounting substrate 9) and the required light transmissivity of the glass layer 3. For example, in the case of using SiO₂-B₂O₃-RO glass (where R is Ca, Sr, Al, Mg, or Ba) as described above, the thickness of the glass paste 33 to be applied may be approximately 10 to 30 µm.

Note that the application of the conductor paste 22 and the glass paste 33 can be implemented by a process such as screen printing, gravure printing, offset printing, or flexographic printing.

### (Third Step)

Then, as shown in Fig. 3(d), the light-emitting-element mounting substrate 9 can be produced by heating and sintering the glass-ceramic green sheet 11, to which the conductor paste 22 and the glass paste 33 have been applied, so as to form the insulating substrate 1 from glass-ceramics, sintering the conductor paste 22 such that the metal layer 2 containing silver is deposited on the main surface of this insulating substrate 1, and melting and then cooling the glass material powder of the glass paste 33 into the transparent glass layer 3 such that the glass layer 3 covers the metal layer 2.

The process for producing a light-emitting-element mounting substrate according to the invention includes the above-described steps, in which the glass paste 33 is produced using powder of the glass material having a softening point higher than the softening point of the glass component contained in the glass-ceramic green sheet 11 and lower than the melting point of silver, and this glass paste 33 is applied so as to cover the conductor paste 22 applied to the main surface of the glass-ceramic green sheet 11. In the produced light-emitting-element mounting substrate 9, it is thus possible for the glass layer 3 to prevent discoloration due to a chemical change such as sulfuration of silver and prevent a change in reflectivity with time.

Specifically, in the above-described production process, since the softening point of the glass material is higher than the softening point of the glass component of the glass-ceramic green sheet 11, the glass material starts to be softened after the glass component has been softened and sintering of silver and glass-ceramics (liquid-phase sintering of the glass component) has been substantially completed. For this reason, it is possible to suppress diffusion of silver into the glass material, suppress discoloration of the glass material (glass layer 3) as a result of diffusion of silver into the glass material, and improve reflectivity. Furthermore, since the softening point of the glass material is lower than the melting point of silver, silver does not melt during the softening of the glass material. Accordingly, it is possible to deposit the metal layer 2 consisting of or consisting primarily of silver on the main surface of the insulating substrate 1 through co-firing with the glass layer 3 that covers the metal layer 2, while suppressing diffusion of silver into the glass layer 3. This makes it possible to provide a production process that enables the production of the light-emitting-element mounting substrate 9 capable of maintaining high optical reflectively of the metal layer 2 over a long period of time.

In this case, the difference between the softening point of the glass material contained in the glass paste 33 and the softening point of the glass component of the glass-ceramic green sheet 11 is preferably approximately 750°C or higher because the softening of the glass material needs to start after the sintering of silver and glass-ceramics has substantially completed as described above.

For example, in a case where the glass component of the glass-ceramic green sheet 11 is borosilicate glass (whose softening point is approximately 800°C), a glass material having a softening point of approximately 870°Cor higher may be used for the glass paste 33.

Furthermore, in the above-described step of applying the conductor paste 22 consisting primarily of silver, the conductor material such as silver is desirably adjusted such that the average particle size of silver after firing is in the range of approximately 2 to 3 µm.

Too large a particle size tends to make the surface of the metal layer 2 coarse and to makes it difficult to sufficiently increase the reflectivity of the metal layer 2 itself. Also, too small a particle size may facilitate diffusion of the glass component contained in the glass-ceramic green sheet 11 into the surface of silver, lower the degree of transparency of the glass layer 3, and thereby reduce reflectivity.

Furthermore, such silver powder can be produced by, for example, an atomizing processing or a wet reduction processing. The production of silver powder by an atomizing processing is performed by, for example, a processing in which jet fluid is sprayed to melted silver such that the melted silver is sequentially powdered and then formed into droplets with the energy of that jet fluid, and the generated droplets are cooled and then formed into powder. The production of silver powder by a wet reduction processing is performed by, for example, a processing in which an aqueous solution of silver ammine complex is produced from a silver nitrate solution and aqueous ammonia, and an organic reducing agent is added to that aqueous solution.

Furthermore, in the above-described production process, at least one of zirconium oxide, aluminum oxide, titanium oxide, and niobium oxide may be added to the glass paste 33. In this case, such a material as zirconium oxide that is contained in the glass layer 3 after firing makes it possible to improve optical reflectivity as in the case of the above-described light-reflecting substrate. The amount of zirconium oxide or the like to be added to the glass paste 33 may, for example, be set, as in the case of the above-described light-reflecting substrate, such that the content of zirconium oxide or the like in the glass layer 3 is approximately 5 to 15% by mass. In this case, it is desirable for zirconium oxide or the like to be added such that it is contained in the glass layer 3 as particles dispersed in the glass layer 3.

Furthermore, the addition of zirconium oxide or the like, for example, of approximately 5 to 15% by mass to the glass paste 33 makes it possible to suppress the flow of the glass paste 33 during firing and to form the glass layer 3 into a predetermined pattern with higher accuracy.

Note that, as in the case of the aforementioned light-reflecting substrate, in a case where the material to be added to the above glass paste is zirconium oxide, it is possible to effectively suppress adhesion of a plating metal to the glass layer 3 of the light-emitting-element mounting substrate 9 after firing. In a case where the material is aluminum oxide, it is possible to improve the property of heat dissipation.

Now, the effects achieved by the process for producing a light-emitting-element mounting substrate 9 according to the invention will be described using a specific example. In the specific example, it is assumed that a produced light-emitting-element mounting substrate 9 includes a portion 1a where a light-emitting element 7 is to be mounted, in the central portion of the upper surface of the insulating substrate 1 having the shape of a square plate that has a side length of approximately 5 mm as viewed in a plan view and a thickness of approximately 500 µm, two metal layers 2 each consisting of silver and formed in a rectangular pattern having external dimensions of approximately 2 mm x 4.5 mm are disposed on the upper surface of the insulating substrate 1 at an interval of approximately 0.1 mm, and these metal layers are covered with a glass layer 3 having a thickness of approximately 10 µm and formed of a 15-µm glass material.

The above-described light-emitting-element mounting substrate 9 was produced through the following steps.

First, a glass-ceramic green sheet 11 was produced by producing a ceramic paste consisting primarily of borosilicate glass and aluminum oxide and then forming the ceramic paste into sheet form by doctor blade processing. Thereafter, a conductor paste 22 produced by kneading silver powder with an organic solvent and a binder was applied in the pattern of the above-described metal layers 2 to the upper surface of the glass-ceramic green sheet 11 by screen printing.

Next, a glass paste 33 was produced by kneading, with an organic solvent and a binder, powder of a glass material (SiO₂-B₂O₃-RO (where R is Sr and Al)) whose softening point is approximately 870°C and higher by approximately 70°Cthan the softening point of the glass component (borosilicate glass described above) contained in the glass-ceramic green sheet 11. This glass paste 33 was then applied by screen printing so as to cover the conductor paste 22 printed on the upper surface of the glass-ceramic green sheet 11.

Then, the glass-ceramic green sheet 11 to which the conductor paste 22 and the glass paste 33 had been applied was heated to approximately 915°C, which produced the light-emitting-element mounting substrate 9 of the above specific example.

Furthermore, as a comparative example, a light-emitting-element mounting substrate (not shown) according to a conventional art was produced by applying a glass paste (not shown) of the conventional art to a conductor paste (not shown) so as to cover the conductor paste and firing them in the same manner as described in the production process of the specific example. The glass paste used in the production process of the comparative example was produced using, in the step of producing a glass paste, borosilicate glass similar to that contained in the glass-ceramic green sheet 11 of the above specific example.

The light-emitting-element mounting substrate 9 of the specific example and the light-emitting-element mounting substrate of the comparative example were compared in terms of mirror reflectivity, by measuring the mirror reflectivity of the surfaces of the metal layers 2 for the light transmitted through the glass layer 3 with a spectrocolorimeter CM-3700d manufactured by KONICA MINOLTA SENSING, INC.

As a result, the light-emitting-element mounting substrate produced as a specific example of the production process of the invention exhibited excellent reflectivity of 90% or higher on average in the visible light range (from 360 nm to 740 nm), whereas the light-emitting-element mounting substrate of the comparative example exhibited reflectivity of 90% or less on average.

Note that a temperature cycling test (in the range of -50°Cto 200°C) and a high temperature/high humidity bias test (HHBT)(at 85°C, 85%RH, and 5 V) were performed on the light-emitting-element mounting substrate 9 of the specific example and the light-emitting-element mounting substrate of the comparative example. Visual inspection on the presence or absence of discoloration of the metal layers 2 consisting of silver showed that no discoloration of the metal layers 2 was found in the light-emitting-element mounting substrates (9) produced by both of the production processes of the specific example and the comparative example.

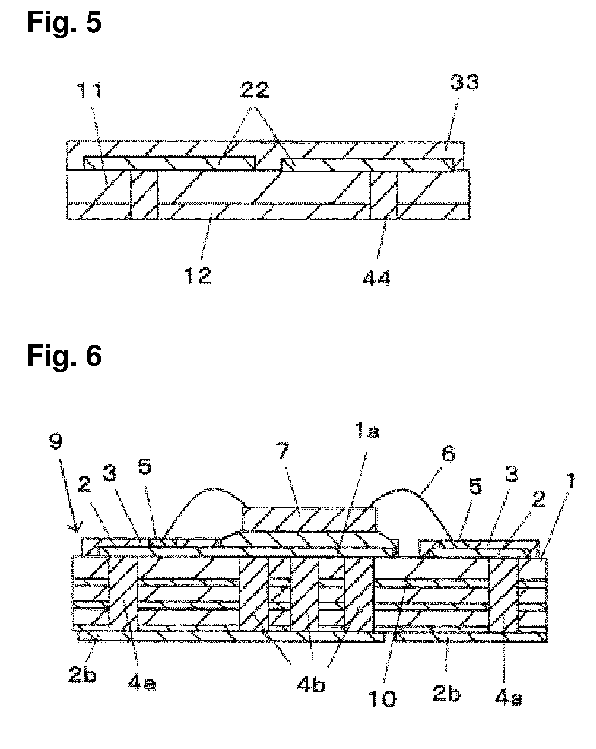

Furthermore, the process for producing a light-emitting-element mounting substrate according to the invention includes the above-described steps and can achieve the following effects in the case where, for example as shown in Fig. 5, a step of producing a constraining glass-ceramic green sheet or constraining glass-ceramic paste 12 using a second glass component whose glass transition point is different from that of the glass component contained in the glass-ceramic green sheet 11, and depositing the constraining glass-ceramic green sheet or constraining glass-ceramic paste 12 on another main surface (in the example of Fig. 5, the lower surface) of the glass-ceramic green sheet 11 that is opposite to the main surface (the main surface on which the light-emitting element 7 is to be mounted) is included prior to heating the glass-ceramic green sheet 11 to which the conductor paste 22 and the glass paste 33 have been applied. Fig. 5 is a cross-sectional view showing a step in another example of the process for producing a light-emitting-element mounting substrate according to the invention. In Fig. 5, the same reference numerals have been given to parts that are the same as in Fig. 3.

Specifically, although the glass paste 33 (glass material) applied so as to cover the conductor paste 22 on the main surface of the glass-ceramic green sheet 11 hardly shrinks at the firing temperature of the glass-ceramic green sheet 11, firing shrinkage of the glass-ceramic green sheet 11 in the plane direction is suppressed by the constraining glass-ceramic green sheet or constraining glass-ceramic paste 12 (constraining layer) produced using the second glass component having a different glass transition point. This makes it possible to suppress the occurrence of stress due to a difference in the amount of shrinkage between the glass-ceramics and the glass layer 3. Accordingly, it is possible to suppress warpage of the insulating substrate 1 caused by stress due to a difference in the amount of shrinkage and to improve the strength of bonding of the glass layer 3 to the insulating substrate 1. Therefore, in this case, warpage of the insulating substrate 1 and detachment of the metal layer 2 caused by warpage of the insulating substrate 1 can be suppressed more effectively, in addition to the ability to suppress a chemical change of the metal layer 2 containing silver. It is thus possible to produce the light-emitting-element mounting substrate 9 with which it is easy to improve the bonding strength of the metal layer 2.

Furthermore, although the progress of so-called multichip mounting, in which a plurality of light-emitting elements 7 are mounted on the main surface of a single insulating substrate 1, narrows the distances (gaps) between the light-emitting elements 7 and creates demand for high dimensional accuracy of the metal layer 2 serving as a wiring conductor for supplying power to the light-emitting elements 7, it is possible with this configuration to achieve high dimensional accuracy of the wiring conductor (metal layer 2).

Furthermore, this production process is also advantageous to the case where a light-emitting-element mounting substrate 9 is produced in consideration of heat dissipation from a light-emitting element 7. Specifically, in order to improve the performance of heat diffusion from the light-emitting element 7, for example as shown in Fig. 6, it is preferable for the light-emitting element 7 to be directly bonded to the metal layer 2 with, for example, a conductive resin or low-melting-point brazing solder (without reference numeral), in which case it is desirable for the glass layer 3 to cover only a portion where the light-emitting element 7 is to be mounted, in order to suppress a chemical change of the metal layer 2. In connection with this, since firing shrinkage of the insulating substrate 1 can be suppressed with the above-described production process, it is possible to increase the dimensional accuracy of the metal layer 2 and the glass layer 3 that are deposited on the main surface of the insulating substrate 1. From this, it is also easy to produce a light-emitting-element mounting substrate 9 such that only a portion of the metal layer 2 where the light-emitting element 7 is to be mounted is covered with the glass layer 3. Fig. 6 is a cross-sectional view showing another example of the light-emitting-element mounting substrate 9 produced by the production process of the invention, and a light-emitting device configured by mounting a light-emitting element on this light-emitting-element mounting substrate 9, or in other words, an example of the light-emitting-element mounting substrate 9 produced by the production process including the step shown in Fig. 5, and a light-emitting device. In Fig. 6, the same reference numerals have been given to constituent elements that are the same as in Fig. 4.

In the example shown in Fig. 6, constraining layers 10 configured by firing constraining glass-ceramic green sheets or constraining glass-ceramic paste 12 are formed inside the insulating substrate 1. In this way, by laminating a plurality of glass-ceramic green sheets (not shown), disposing constraining glass-ceramic green sheets or constraining glass-ceramic paste 12 between the layers, and firing them, the insulating substrate 1 in which the constraining layers 10 are disposed between a plurality of insulating layers (without reference numeral) is produced. This improves the effect of suppressing shrinkage of the glass-ceramic green sheet consisting of a plurality of layers in the plane direction. In this case, a plurality of glass-ceramic green sheets are laminated after the constraining glass-ceramic green sheet or constraining glass-ceramic paste 12 has been deposited on the main surface of a glass-ceramic green sheet (i.e., a lower glass-ceramic green sheet, not shown) other than the (uppermost) glass-ceramic green sheet 11 including the portion 1a of the main surface where the light-emitting element 7 is to be mounted.

Note that in the example shown in Fig. 6, through-conductors 4b passing through the insulating substrate 1 in the thickness direction are disposed on the underside of portion 1a of the insulating substrate 1 where the light-emitting element 7 is to be mounted. These through-conductors 4b function as, for example, heat transfer materials for dissipating heat generated by the light-emitting element 7 to the outside. These through-conductors 4b can also be formed of the same material and by the same process as used for the aforementioned through-conductors 4a.

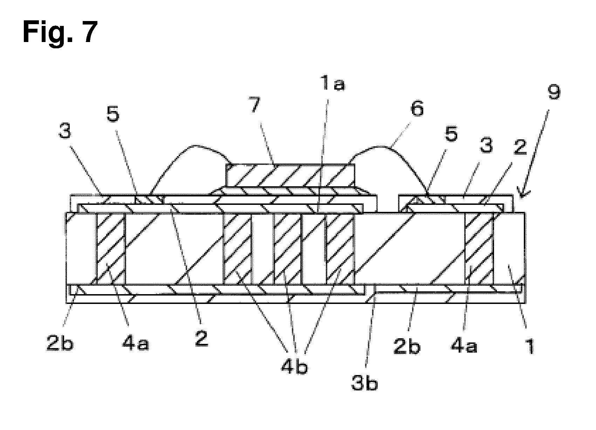

Furthermore, another example of the light-emitting-element mounting substrate 9 produced by the production process of the invention is shown in Fig. 7. Fig. 7 is a cross-sectional view showing another example of the light-emitting-element mounting substrate 9 produced by the production process of the invention, and the light-emitting device configured by mounting a light-emitting element 7 on this light-emitting-element mounting substrate 9. In Fig. 7, the same reference numerals have been given to constituent elements that are the same as in Figs. 4 and 6.

In the example shown in Fig. 7, a light-emitting-element mounting substrate 9 is produced by applying another glass paste (not shown) in layers to the lower surface of the glass-ceramic green sheet 11 to which the conductor paste 22 and the glass paste 33 has been applied, before heating the glass-ceramic green sheet 11. Then, another glass layer 3b formed by melting and cooling the applied glass paste is deposited on the lower surface of the insulating substrate 1.

In the case where the other glass paste is applied to the lower surface of the glass-ceramic green sheet 11 and thereafter heated, stress that accompanies shrinkage of the glass paste 33 as a result of heating and stress that accompanies shrinkage of the other glass paste on the lower surface side of the glass-ceramic green sheet 11 can offset each other. Therefore, this is effective in terms of suppressing warpage when heating the glass-ceramic green sheet 11. Note that the other glass paste applied to the lower surface of the glass-ceramic green sheet 11 may, for example, be the same glass paste 33 as used to cover the conductor paste 22. Furthermore, in a case where the conductor paste 22 and the glass paste 33 are applied to only the lower surface of the glass-ceramic green sheet 11, such another glass paste for suppressing warpage may be applied to the upper surface side of the glass-ceramic green sheet 11.

### (Another Example of Process for Producing Light-Emitting-Element Mounting Substrate)

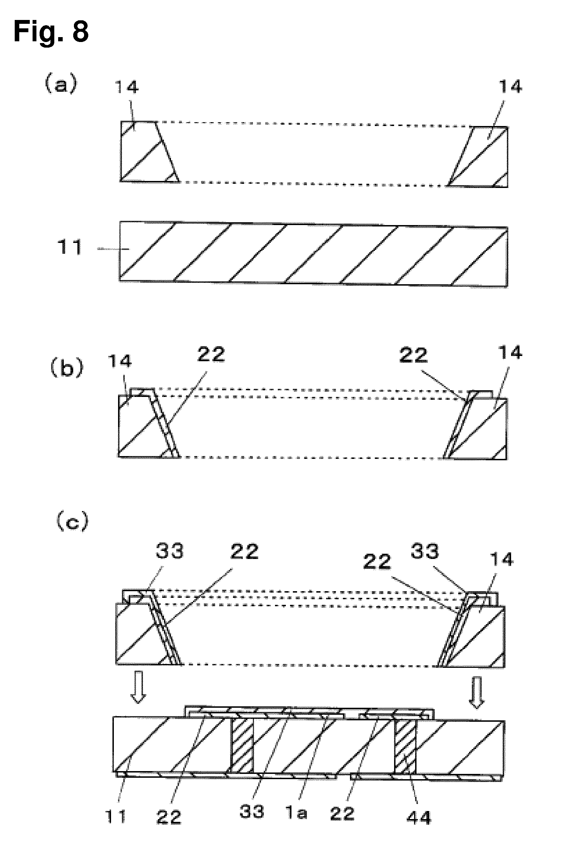

Next, another example of the process for producing a light-emitting-element mounting substrate according to the invention will be described with reference to Fig. 8. Note that Figs. 8(a) to 8(c) are cross-sectional views showing another example of the process for producing a light-emitting-element mounting substrate according to the invention in order of steps. In Fig. 8, the same reference numerals have been given to constituent elements that are the same as in Figs. 3 and 4.

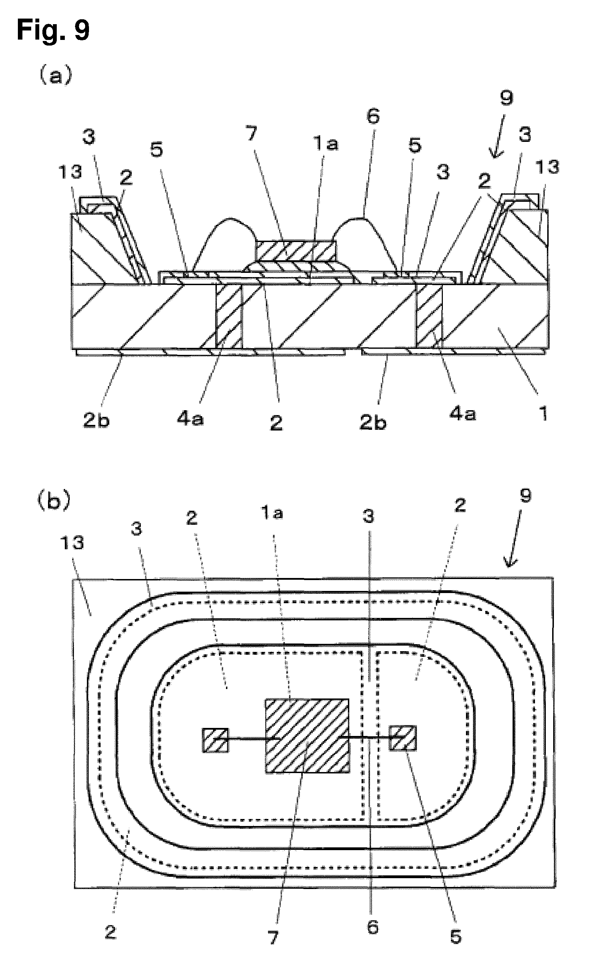

A light-emitting-element mounting wiring substrate produced by the production process of this other example is, for example as shown in Fig. 9, a light-emitting-element mounting substrate 9 in which a frame portion 13 formed of glass-ceramics is further laminated on the main surface of the insulating substrate 1 so as to surround the portion 1a where the light-emitting element 7 is to be mounted, and the metal layer 2 is also deposited on the inner side surface of the frame portion 13. Note that in the following description of the steps, the description of parts that are the same as in the above-described production process (the process for producing the light-emitting-element mounting substrate 9 with no frame portion 13) has been omitted.

The light-emitting-element mounting substrate 9 as shown in Fig. 9 can more effectively utilize the light emitted from the light-emitting element 7 because the metal layer 2 on the inner side surface of the frame portion 13 increases the surface area where light is reflected. In this case, since the metal layer 2 on the inner side surface of the frame portion 13 is also covered with the glass layer 3, it is also possible to suppress discoloration of the metal layer 2 on the inner side surface of the frame portion 13 due to a chemical reaction of silver.

Although in the example shown in Fig. 9, the frame portion 13 has a rectangular shape with arcuately-formed corners, it may be of, for example, a quadrangular shape, an ellipsoidal shape, or a circular shape. Furthermore, the inner side surface of the frame portion 13 is inclined so as to enable effective light emission to the outside (upward).

First, in the above-described first step, a frame-shaped glass-ceramic green sheet 14 is produced in addition to the glass-ceramic green sheet 11 as shown in Fig. 8(a), and the conductor paste 22 is also applied to the inner side surface of the frame-shaped glass-ceramic green sheet 14 as shown in Fig. 8(b).

The frame-shaped glass-ceramic green sheet 14 can be produced with the same material and by the same process as for the glass-ceramic green sheet 11, by producing a flat-plate-like glass-ceramic green sheet (not shown) and subjecting a central portion of this flat-plate-like glass-ceramic green sheet to punching processing using a mold or the like such that the flat-plate-like glass-ceramic green sheet is formed into a frame shape.

The same conductor paste 22 as applied to the main surface of the glass-ceramic green sheet 11, which is to be the insulating substrate 1, may be used as the conductor paste 22 to be applied to the inner side surface of the frame-shaped glass-ceramic green sheet 14.

Note that the first step of this another embodiment is the same as the aforementioned first step, with the exception of adding the step of preparing the frame-shaped glass-ceramic green sheet 14 and applying the conductor paste 22 to the inner side surface of the frame-shaped glass-ceramic green sheet 14.

Next, in the above second step, the glass paste 33 is applied so as to also cover the conductor paste 22 applied to the inner side surface of the frame-shaped glass-ceramic green sheet 14, as shown in Fig. 8(c).

The same glass paste 33 as described above may also be used as the glass paste 33 to be applied so as to cover the conductor paste 22 applied to the inner side surface of the frame-shaped glass-ceramic green sheet 14.

The frame-shaped glass-ceramic green sheet 14 with the conductor paste 22 and the glass paste 33 having been sequentially applied to the inner side surface thereof is laminated on the main surface (upper surface) of the glass-ceramic green sheet 11. At this time, the application of the conductor paste 22 and the glass paste 33 to the glass-ceramic green sheet 11 has been completed in the same manner as described in the above second step. Laminating the frame-shaped glass-ceramic green sheet 14 on the upper surface of the glass-ceramic green sheet 11 forms a stacked body (without reference numeral). This stacked body is configured such that the portion 1a where the light-emitting element 7 is to be mounted is included in the main surface of the glass-ceramic green sheet 11, the conductor paste 22 and the glass paste 33 have been sequentially applied to the main surface of the glass-ceramic green sheet 11, the frame-shaped glass-ceramic green sheet 14 that surrounds the portion 1a where the light-emitting element 7 is to be mounted has been laminated thereon, and the conductor paste 22 and the glass paste 33 are sequentially deposited on the inner side surface of the frame-shaped glass-ceramic green sheet 14. Note that a conductor paste (without reference numeral) that is to be another metal layer 2b is deposited on the lower surface of the glass-ceramic green sheet 11.

This second step is also the same as the aforementioned second step, with the exception of adding the step of sequentially applying the conductor paste 22 and the glass paste 33 to the inner side surface of the frame-shaped glass-ceramic green sheet 14 and laminating this frame-shaped glass-ceramic green sheet 14 on the main surface of the glass-ceramic green sheet 11.

Then, in the above third step, the insulating substrate 1 and the frame portion 13 are integrally fired by heating the stacked body together with the conductor pastes 22 applied to the main surface of the glass-ceramic green sheet 11 and the inner side surface of the frame-shaped glass-ceramic green sheet 14, and the glass pastes 33 that cover these conductor pastes 22.

Through this heating, the conductor paste 22 and the glass paste 33 applied to the inner side surface of the frame-shaped glass-ceramic green sheet 14, in addition to the conductor paste 22 and the glass paste 33 applied to the main surface of the glass-ceramic green sheet 11, are formed respectively into the metal layer 2 and the glass layer 3 that covers the metal layer 2.

Here, in a case where a glass material whose softening point is close to the peak firing temperature is used as the glass material for producing the glass paste 33, excessive softening and flowing of the glass paste 33 can be suppressed and accordingly detachment of the glass paste 33 (glass layer 3) from the inner side surface of the frame portion 13 can be more effectively suppressed.

Furthermore, since the softening point of the glass paste 33 is higher than the softening points of the glass components of the glass-ceramic green sheet 11 and the frame-shaped glass-ceramic green sheet 14, the glass paste 33 starts to be softened after these glass components have been softened and the sintering of silver of the conductor pastes 22 and glass-ceramics (stacked body) (liquid-phase sintering of the glass component) has been substantially completed. For this reason, it is possible to suppress diffusion of the above silver into the glass material for the glass paste 33, suppress discoloration of the glass material (the fired glass layer 3) due to diffusion of silver into the glass material, and improve reflectivity. Furthermore, since the softening point of the glass material is lower than the melting point of silver, silver does not melt during the softening of the glass material. Accordingly, it is possible to deposit the metal layer 2 containing silver on the main surface of the insulating substrate 1 and the inner side face of the frame portion 13 through co-firing with the glass layer 3 that covers the metal layer 2, while suppressing diffusion of silver into the glass layer 3. Therefore, in the case of this another embodiment as well, it is possible to provide a production process that enables the production of a light-emitting-element mounting substrate 9 capable of maintaining high optical reflectivity of the metal layer 2 over a long period of time.

In this case as well, the difference between the softening point of the glass material contained in the glass paste 33 and the softening point of the glass component of the glass-ceramic green sheet 11 is preferably approximately 750°Cor higher because the softening of the glass material needs to start after the sintering of silver and the glass-ceramics has substantially ended as described above.

For example, in a case where the glass components of the glass-ceramic green sheet 11 and the frame-shaped glass-ceramic green sheet 14 are both borosilicate glass (whose softening point is approximately 800°C), a glass material whose softening point is approximately 870°Cor higher may be used for the glass paste 33.

Note that in the case where the metal layer 2 on the main surface of the insulating substrate 1 is formed up to the vicinity of the frame portion 13 and covered with the glass layer 3, there is the possibility that circuits (e.g., the metal layers 2) on the main surface of the insulating substrate 1 may be short-circuited through the metal layer 2 formed on the entire surface of the frame portion 13 due to insufficient insulation of the glass layer 3. Furthermore, in a case where the inner side surface of the frame portion 13 is inclined in order to improve the efficiency of reflection of the light-emitting element 7, adhesion failures may occur in the inner peripheral portion of the region where the insulating substrate 1 and the frame portion 13 are connected (a frame-shaped bonding region of the stacked body between the glass-ceramic green sheet 11 and the frame-shaped glass-ceramic green sheet 14) because the application of pressure during lamination tends to be insufficient. If adhesion failures occur, for example in a plating step performed after firing, a plating solution will go into a portion where adhesion between the insulating substrate 1 and the frame portion 13 is insufficient, forming an unnecessary plating metal layer (not shown), as a result of which circuits on the main surface of the insulating substrate 1 will be short-circuited.

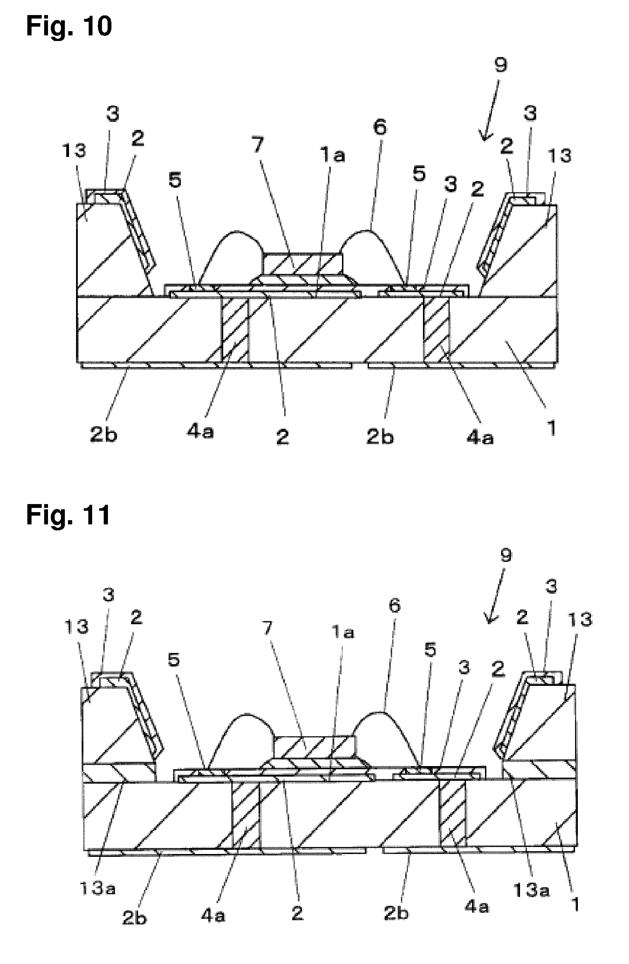

In order to prevent such short-circuiting, Figs. 10 to 12 show other examples of the light-emitting-element mounting substrate 9 (light-emitting device) with the frame portion 13 produced by the production process of the invention. Note that in Figs. 10 to 12, the same reference numerals have been given to constituent elements that are the same as in Figs. 4 and 9.

Fig. 10 shows an example in which the metal layer 2 is deposited partway on the inner side surface of the frame portion 13 and covered with the glass layer 3. In this case, the lower end of the metal layer 2 on the inner side surface of the frame portion 13 can be spaced away from the metal layer 2 on the upper surface of the insulating substrate 1. This enables more effective suppression of electrical short-circuiting between the metal layer 2 on the frame portion 13 and the metal layer 2 on the main surface of the insulating substrate 1.

Fig. 11 shows an example in which an auxiliary frame portion 13a with no metal layer 2 deposited thereon and no inclination on its inner side surface is disposed between the insulating substrate 1 and the frame portion 13 at which the metal layer 2 is deposited on the entire inner side surface thereof. In this case as well, it is easy to prevent short-circuiting because the distance between the metal layer 2 on the main surface of the insulating substrate 1 and the metal layer 2 on the frame portion 13 can be increased.

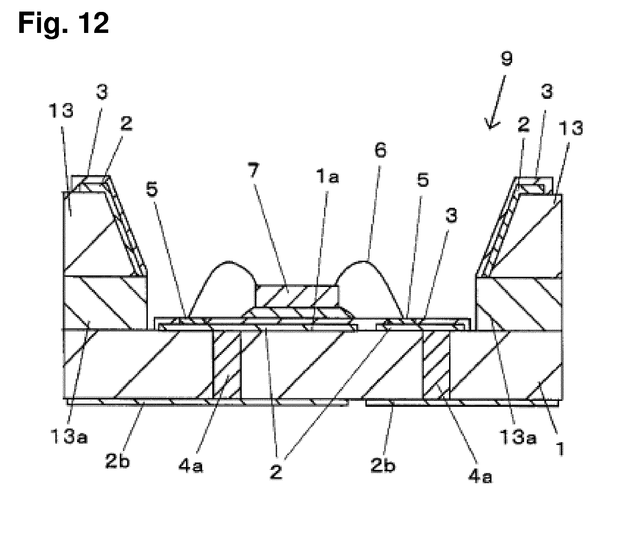

Fig. 12 shows an example in which an auxiliary frame portion 13a whose inner side surface is positioned closer to the center of the insulating substrate 1 than the inner side surface of the frame portion 13 is disposed between the frame portion 13 and the insulating substrate 1, and the inner side surface of the auxiliary frame portion 13a is formed as an insulating region. In the production process, in a case where the glass paste 33 has been softened and is to fall off the upper surface of the conductor paste 22, the upper surface portion of the auxiliary frame portion 13a serves to suppress such falling-off.

### Reference Signs List

- 1:: Insulating substrate
- 1a:: Portion where the light-emitting element is to be mounted (Mounting portion)
- 2:: Metal layer
- 2b:: Another metal layer
- 3:: Glass layer
- 3b: Another glass layer
- 4a:: Through-conductor
- 4b:: Through-conductor
- 5:: Metal plating layer
- 6:: Bonding wire
- 7:: Light-emitting element
- 9:: Light-emitting-element mounting substrate
- 10:: Constraining layer
- 11:: Glass-ceramic green sheet
- 12:: Constraining glass-ceramic green sheet or constraining glass-ceramic paste
- 13:: Frame portion
- 13a:: Auxiliary frame portion
- 14:: Frame-shaped glass-ceramic green sheet
- 22:: Conductor paste
- 33:: Glass paste
- 44:: Conductor paste for through-conductor

## Claims

1. A light-reflecting substrate, comprising:
an insulating substrate; and
a metal layer containing silver and deposited on a main surface of the insulating substrate,
wherein the metal layer is covered with a glass layer having a softening point lower than a melting point of silver, and
a surface of the glass layer on an opposite side of the metal layer side is silver-free.

2. The light-reflecting substrate according to claim 1, wherein at least one of the metal layer and the glass layer contains at least one of cesium, rubidium, and strontium.

3. The light-reflecting substrate according to claim 1, wherein the glass layer contains at least one of zirconium oxide, aluminum oxide, titanium oxide, and niobium oxide.

4. The light-reflecting substrate according to any one of claims 1 to 3, wherein
the insulating substrate is made of glass-ceramics, the insulating substrate, the metal layer, and the glass layer are formed by co-firing, and
the glass layer is formed by firing a first glass material, a softening point of the first glass material being higher than a softening point of a second glass material which is to be a glass component of the glass-ceramics by the co-firing and lower than the melting point of silver.

5. A light-emitting-element mounting substrate, comprising:
the light-reflecting substrate according to any one of claims 1 to 4; and
a mounting portion where a light-emitting element is to be mounted, in the main surface of the insulating substrate to which the silver-containing metal layer has been deposited.

6. A light-emitting device, comprising:
the light-emitting-element mounting substrate according to claim 5; and
a light-emitting element mounted on the mounting portion.

7. A method for manufacturing a light-emitting-element mounting substrate, comprising:
a first step of preparing a glass-ceramic green sheet and applying a conductor paste to at least part of a main surface of the glass-ceramic green sheet, the conductor paste having been produced by dispersing a conductor material consisting of or consisting primarily of silver in an organic solvent;
a second step of producing a glass paste using powder of a glass material having a softening point higher than a softening point of a glass component contained in the glass-ceramic green sheet and lower than a melting point of silver, and applying the glass paste so as to cover the conductor paste applied to the main surface of the glass-ceramic green sheet; and
a third step of heating and sintering the glass-ceramic green sheet to which the conductor paste and the glass paste have been applied, so as to form an insulating substrate composed of glass-ceramics, sintering the conductor paste so as to deposit a metal layer consisting of or consisting primarily of silver on a main surface of the insulating substrate, and melting and then cooling the powder of the glass material of the glass paste so as to form a transparent glass layer with which the metal layer is covered.

8. The method for manufacturing a light-emitting-element mounting substrate according to claim 7, wherein at least one of cesium, rubidium, and strontium is added to at least one of the conductor paste produced in the first step and the glass paste produced in the second step.

9. The method for manufacturing a light-emitting-element mounting substrate according to claim 7, wherein at least one of zirconium oxide, aluminum oxide, titanium oxide, and niobium oxide is added to the glass paste produced in the second step.

10. The method for manufacturing a light-emitting-element mounting substrate according to claim 7, comprising,
prior to heating the glass-ceramic green sheet to which the conductor paste and the glass paste have been applied,
a step of producing a constraining glass-ceramic green sheet or a constraining glass-ceramic paste using a second glass component having a glass transition point different from that of the glass component contained in the glass-ceramic green sheet, and depositing the constraining glass-ceramic green sheet or the constraining glass-ceramic paste on another main surface of the glass-ceramic green sheet that is opposite to the main surface.

11. The method for manufacturing a light-emitting-element mounting substrate according to claim 7, wherein
the first step further includes a step of preparing a frame-shaped glass-ceramic green sheet in addition to the glass-ceramic green sheet and applying the conductor paste also to an inner side surface of the frame-shaped glass-ceramic green sheet, and
the second step further includes a step of applying the glass paste so as to cover the conductor paste applied to the inner side surface of the frame-shaped glass-ceramic green sheet, and laminating the frame-shaped glass-ceramic green sheet on the main surface of the glass-ceramic green sheet so as to form a frame portion that surrounds a portion where the light-emitting element is to be mounted.
